(19) Europäisches Patentamt / European Patent Office / Office européen des brevets

(11) **EP 4 277 299 A1**

(12) **EUROPEAN PATENT APPLICATION**
published in accordance with Art. 153(4) EPC

(43) Date of publication:
**15.11.2023 Bulletin 2023/46**

(21) Application number: **21917768.0**

(22) Date of filing: **28.12.2021**

(51) International Patent Classification (IPC):
*H04R 17/00* (2006.01)   *H01L 41/047* (2006.01)
*H01L 41/053* (2006.01)   *H01L 41/09* (2006.01)
*H01L 41/18* (2006.01)

(52) Cooperative Patent Classification (CPC):
**H04R 17/00; H10N 30/20; H10N 30/85;
H10N 30/87; H10N 30/88**

(86) International application number:
**PCT/JP2021/048844**

(87) International publication number:
**WO 2022/149548 (14.07.2022 Gazette 2022/28)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.01.2021 JP 2021002012**

(71) Applicant: **FUJIFILM Corporation
Tokyo 106-8620 (JP)**

(72) Inventors:
• **KAGAWA Yusuke
  Minamiashigara-shi, Kanagawa 250-0193 (JP)**
• **TAHARA Tomoko
  Minamiashigara-shi, Kanagawa 250-0193 (JP)**

(74) Representative: **Klunker IP
Patentanwälte PartG mbB
Destouchesstraße 68
80796 München (DE)**

(54) **PIEZOELECTRIC FILM**

(57)   An object of the present invention is to provide a piezoelectric film including an electrode layer on each of both surfaces of a piezoelectric layer, and a protective layer provided on the surface of the electrode layer and having a low connection resistance between the electrode layer and a lead wire. The object is achieved by providing the piezoelectric film including a piezoelectric layer, an electrode layer provided on each of both surfaces of the piezoelectric layer, a protective layer provided to cover the electrode layer and having through-holes, a conductive filling member with which the through-holes are filled, and a lead wire provided in contact with the filling member, in which in at least one of the lead wires, in a case where a length of a region in contact with the filling member in a plane direction is defined as A, and a length of the surface with respect to the length A in the plane direction is defined as B, B/A is 1.5 or greater.

FIG. 1

EP 4 277 299 A1

**Description**

**BACKGROUND OF THE INVENTION**

1. Field of the Invention

The present invention relates to a piezoelectric film used for an electroacoustic transducer or the like.

2. Description of the Related Art

Flexible displays, such as organic electroluminescence displays, which are formed of flexible substrates such as plastics have been developed.

In a case where such a flexible display is used as an image display device also serving as a sound generator that reproduces a sound together with an image, such as a television receiver, a speaker which is an acoustic device for generating a sound is required.

Here, examples of typical shapes of speakers of the related art include a funnel-like so-called cone shape and a spherical dome shape. However, in a case where such a speaker is intended to be incorporated in the above-described flexible display, there is a concern that the lightness and the flexibility, which are advantages of the flexible display, are impaired. Further, in a case where the speaker is attached externally, since the speaker is troublesome to carry and difficult to install on a curved wall, there is a concern that a beautiful appearance is impaired.

Meanwhile, a piezoelectric film (electroacoustic conversion film) described in JP2015-29270A is known as a piezoelectric film that can be used as a speaker capable of being integrated with a flexible display without impairing lightness and flexibility.

This piezoelectric film is a piezoelectric film including a piezoelectric layer (polymer-based piezoelectric composite material) obtained by dispersing piezoelectric particles in a viscoelastic matrix consisting of a polymer material having a viscoelasticity at room temperature, an electrode layer (thin film electrode) formed on each of both surfaces of the piezoelectric layer, and a protective layer formed on the surface of the electrode layer, in which a maximal value at which a loss tangent at a frequency of 1 Hz acquired by dynamic viscoelasticity measurement is 0.1 or greater is present in a temperature range of 0°C to 50°C.

**SUMMARY OF THE INVENTION**

The piezoelectric film described in JP2015-29270A has excellent piezoelectric characteristics. Further, since the piezoelectric layer of the piezoelectric film is obtained by dispersing the piezoelectric particles in a polymer material, the piezoelectric film formed of this piezoelectric layer has satisfactory flexibility.

Therefore, according to this piezoelectric film, for example, an electroacoustic conversion film or the like which can be used for a flexible speaker or the like, has flexibility, and has satisfactory piezoelectric characteristics can be realized.

In order to drive such a piezoelectric film including a piezoelectric layer, an electrode layer on each of both surfaces of the piezoelectric layer, and a protective layer covering the electrode layer, the electrode layer and an external device such as a power supply device for driving are required to be connected to each other with a lead wire.

Various methods can be considered as a method of connecting the electrode layer of the piezoelectric film and the lead wire to each other. As an example, a method of connecting a lead wire to an electrode layer by providing through-holes in a protective layer, filling the through-holes with a conductive material consisting of a conductive paste and the like, and connecting the conductive material and the lead wire to each other is exemplified.

Here, even in any connection method, it is preferable that the resistance of the connection between the electrode layer and the lead wire is low in order to efficiently drive the piezoelectric film, that is, the piezoelectric layer.

The present invention has been made to solve the above-described problems of the related art, and an object thereof is to provide a piezoelectric film including an electrode layer on each of both surfaces of a piezoelectric layer, and a protective layer provided on the surface of the electrode layer and capable of decreasing the connection resistance between the electrode layer and a lead wire.

In order to solve the above-described problem, the present invention has the following configurations.

[1] A piezoelectric film comprising: a piezoelectric layer; electrode layers provided on both surfaces of the piezoelectric layer; protective layers provided to cover the electrode layers and having one or more through-holes; a conductive filling member which fills the through-holes of the protective layer; and lead wires provided in contact with the filling member and to connect the piezoelectric film with an external device, in which in at least one lead wire, in a case where a length of a region on a surface, which is in contact with at least the filling member, in a plane direction is defined as A, and a length of the surface with respect to the length A in the plane direction is defined as B, B/A is 1.5 or greater.

[2] The piezoelectric film according to [1], in which the through-holes of the protective layer are fulfilled with the filling member.

[3] The piezoelectric film according to [1] or [2], in which the lead wire includes a conductive main body and a conductive coating layer with which the main body is coated.

[4] The piezoelectric film according to any one of [1] to [3], in which the filling member is present continuously from the through-holes of the protective layer to a surface of the protective layer, which faces the lead wire.

[5] The piezoelectric film according to any one of [1] to [4], in which the surface of the region of the lead wire, which is in contact with at least the filling member, has at least one of a recess having a portion with a length in the plane direction greater than a length of an open end in the plane direction or a projection having a portion with a length in the plane direction greater than a length of a base in the plane direction.

[6] The piezoelectric film according to any one of [1] to [5], in which the lead wire has a sheet shape.

[7] The piezoelectric film according to any one of [1] to [6], in which the piezoelectric layer is a polymer-based piezoelectric composite material that contains piezoelectric particles in a matrix containing a polymer material.

[8] The piezoelectric film according to [7], in which the polymer material contains a cyanoethyl group.

According to the present invention, in a piezoelectric film including an electrode layer on each of both surfaces of a piezoelectric layer, and a protective layer provided on the surface of the electrode layer, the connection resistance between the electrode layer and a lead wire can be decreased.

## BRIEF DESCRIPTION OF THE DRAWINGS

Fig. 1 is a view conceptually illustrating an example of a piezoelectric film of the present invention.
Fig. 2 is a schematic plan view illustrating the piezoelectric film illustrated in Fig. 1.
Fig. 3 is a partially enlarged schematic view illustrating the piezoelectric film illustrated in Fig. 1.
Fig. 4 is a view conceptually illustrating a part of another example of the piezoelectric film of the present invention.
Fig. 5 is a conceptual view for describing a method of preparing the piezoelectric film illustrated in Fig. 1.
Fig. 6 is a conceptual view for describing a method of preparing the piezoelectric film illustrated in Fig. 1.
Fig. 7 is a conceptual view for describing a method of preparing the piezoelectric film illustrated in Fig. 1.
Fig. 8 is a conceptual view for describing a method of preparing the piezoelectric film illustrated in Fig. 1.
Fig. 9 is a conceptual view for describing a method of preparing the piezoelectric film illustrated in Fig. 1.
Fig. 10 is a conceptual view for describing a method of preparing the piezoelectric film illustrated in Fig. 1.
Fig. 11 is a conceptual view for describing a method of preparing the piezoelectric film illustrated in Fig. 1.
Fig. 12 is a conceptual view for describing a method of measuring an electric resistance in an example.

## DESCRIPTION OF THE PREFERRED EMBODIMENTS

Hereinafter, a piezoelectric film according to the embodiment of the present invention will be described in detail based on suitable examples illustrated in the accompanying drawings.

Descriptions of the configuration requirements described below may be made based on representative embodiments of the present invention, but the present invention is not limited to such embodiments.

In the present specification, a numerical range shown using "to" indicates a range including numerical values described before and after "to" as a lower limit value and an upper limit value.

In addition, the views shown below are conceptual views for describing the present invention, and the thickness of each layer, the size of the through-hole, the positional relationship of each member (site), and the size of each member are different from the actual ones.

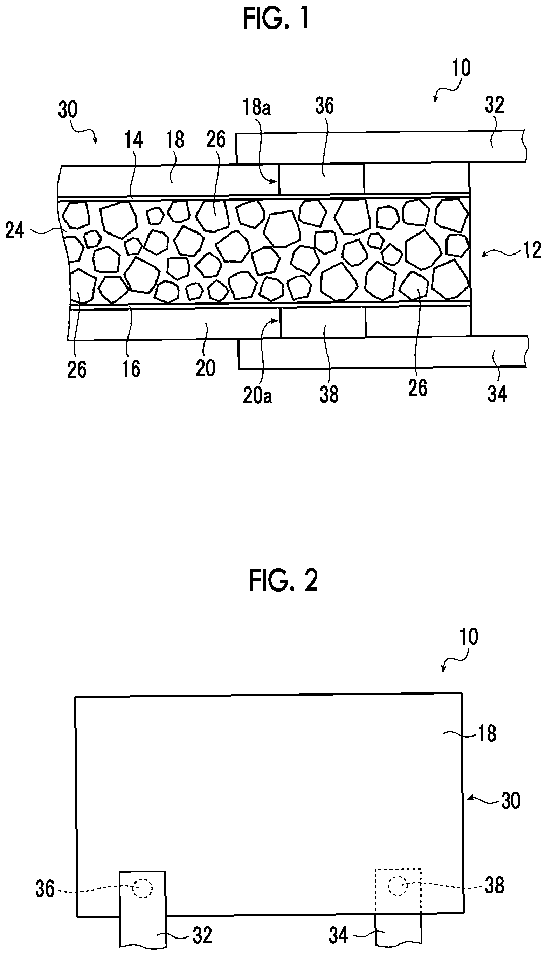

Fig. 1 and Fig. 2 conceptually illustrate an example of the piezoelectric film according to the embodiment of the present invention.

Fig. 1 is a view conceptually illustrating a cross section of the piezoelectric film cut in a thickness direction. Fig. 2 is a plan view of the piezoelectric film illustrated in Fig. 1. Further, the thickness direction of the piezoelectric film is a lamination direction of a piezoelectric layer, an electrode layer, a protective layer, and the like described below. Further, the plan view is a view illustrating the piezoelectric film according to the embodiment of the present invention as viewed in the thickness direction.

As illustrated in Fig. 1, a piezoelectric film 10 includes a piezoelectric layer 12, a first electrode layer 14 laminated on one surface of the piezoelectric layer 12, a first protective layer 18 laminated on the surface of the first electrode layer 14, a second electrode layer 16 laminated on the other surface of the piezoelectric layer 12, a second protective layer 20 laminated on the surface of the second electrode layer 16, a first lead wire 32 and a second lead wire 34, and a first filling member 36 and a second filling member 38.

In the piezoelectric film 10 according to the embodiment of the present invention, the first protective layer 18 is provided with a through-hole 18a. The through-hole 18a is filled with the first filling member 36. The first lead wire 32 is provided on the first protective layer 18 to cover the first filling member 36. In the piezoelectric film 10, the first lead wire 32 and the first electrode layer 14 are electrically connected due to this configuration.

Similarly, the second protective layer 20 is provided with a through-hole 20a. The through-hole 20a is filled with the second filling member 38. The second lead wire 34 is provided on the second protective layer 20 to cover the second filling member 38. In the piezoelectric film 10, the second lead wire 34 and the second electrode layer 16 are electrically connected due to this configuration.

Here, in the piezoelectric film 10 according to the embodiment of the present invention, in a case where the length of a region on the surface of the first lead wire 32 that is in contact with at least the first filling member 36 in the plane direction is defined as A, and the length of the surface with respect to the length A in the plane direction is defined as B, B/A is 1.5 or greater. Similarly, in a case where the length of a region on the surface of the second lead wire 34 that is in contact with at least the second filling member 38 in the plane direction is defined as A, and the length of the surface with respect to the length A is defined as B, B/A is 1.5 or greater.

That is, in the piezoelectric film according to the embodiment of the present invention, B/A, which is the length of an actual surface of the lead wire in a unit length in the plane direction, is 1.5 or greater (B/A $\geq$ 1.5).

As described below, since the piezoelectric film 10 according to the embodiment of the present invention has such a configuration, the resistance value of the connection between the first lead wire 32 and the first electrode layer 14 and the resistance value of the connection between the second lead wire 34 and the second electrode layer 16 are decreased, and thus efficient driving can be carried out.

In the present invention, the plane direction is a plane direction of a main surface of a sheet-like material such as the protective layer or the electrode layer. Further, the main surface is a maximum surface of the sheet-like material.

That is, the plane direction in the piezoelectric film 10 is a direction orthogonal to the thickness direction. As described above, the thickness direction in the piezoelectric film 10 is a lamination direction of the piezoelectric layer, the electrode layer, the protective layer, and the like. That is, the plane direction in the piezoelectric film 10 according to the embodiment of the present invention is a direction orthogonal to the lamination direction of the piezoelectric layer, the electrode layer, the protective layer, and the like.

In the piezoelectric film 10 according to the embodiment of the present invention, the piezoelectric layer 12 contains the piezoelectric particles 26, which are piezoelectric particles, in a matrix 24 containing a polymer material. That is, the piezoelectric layer 12 is a polymer-based piezoelectric composite material.

Here, the polymer-based piezoelectric composite material (piezoelectric layer 12) is used, for example, in an electroacoustic conversion film. It is preferable that the polymer-based piezoelectric composite material used in the electroacoustic conversion film satisfies the following requirements. Further, in the present invention, room temperature is in a range of 0°C to 50°C.

(i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have suitable flexibility. In addition, in a case where strain energy is diffused into the outside as heat, the stress is able to be relieved. Therefore, the polymer-based piezoelectric composite material is required to have a suitably large loss tangent.

(ii) Acoustic quality

In a speaker, the piezoelectric particles vibrate at a frequency of an audio band of 20 Hz to 20 kHz, and the vibration energy causes the entire vibration plate (polymer-based piezoelectric composite material) to vibrate integrally so that a sound is reproduced. Therefore, in order to increase the transmission efficiency of the vibration energy, the polymer-based piezoelectric composite material is required to have appropriate hardness. In addition, in a case where the frequencies of the speaker are smooth as the frequency characteristic thereof, an amount of change in acoustic quality in a case where the lowest resonance frequency $f_0$ is changed in association with an amount of a change in the curvature of the speaker decreases. Therefore, the polymer-based piezoelectric composite material is required to have a suitably large loss tangent.

It is known that the lowest resonance frequency $f_0$ of the vibration plate for a speaker is represented by the following equation. Here, s represents the stiffness of the vibration system and m represents the mass.

Lowest resonance frequency :

$$f_0 = \frac{1}{2\pi} \sqrt{\frac{s}{m}}$$

Here, as the degree of curvature of the piezoelectric film, that is, the radius of curvature of the curved portion increases, the mechanical stiffness s decreases, and thus the lowest resonance frequency $f_0$ decreases. That is, the acoustic quality (the volume and the frequency characteristics) of the speaker changes depending on the radius of curvature of the piezoelectric film.

That is, the flexible polymer-based piezoelectric composite material used as an electroacoustic conversion film is required to exhibit a behavior of being rigid with respect to a vibration of 20 Hz to 20 kHz and being flexible with respect to a vibration of less than or equal to a few Hz. In addition, the loss tangent of a polymer-based piezoelectric composite material is required to be suitably large with respect to the vibration of all frequencies of 20 kHz or less.

In general, a polymer solid has a viscoelasticity relieving mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer-based piezoelectric composite material (piezoelectric layer 12), the polymer-based piezoelectric composite material exhibiting a behavior of being rigid with respect to a vibration of 20 Hz to 20 kHz and being flexible with respect to a vibration of less than or equal to a few Hz is realized by using a polymer material whose glass transition point is room temperature, that is, a polymer material having a viscoelasticity at room temperature as a matrix. In particular, from the viewpoint that such a behavior is suitably exhibited, it is preferable that a polymer material in which the glass transition point at a frequency of 1 Hz is at room temperature, that is, in a range of 0°C to 50°C is used for a matrix of the polymer-based piezoelectric composite material.

As the polymer material having a viscoelasticity at room temperature, various known materials can be used. It is preferable that a polymer material in which the maximal value of a loss tangent Tan$\delta$ at a frequency of 1 Hz according to a dynamic viscoelasticity test at room temperature, that is, in a range of 0°C to 50° is 0.5 or greater is used as the polymer material.

In this manner, in a case where the polymer-based piezoelectric composite material is slowly bent due to an external force, stress concentration on the interface between the polymer matrix and the piezoelectric particles at the maximum bending moment portion is relieved, and thus high flexibility can be expected.

In the polymer material having a viscoelasticity at room temperature, it is preferable that a storage elastic modulus (E') at a frequency of 1 Hz according to the dynamic viscoelasticity measurement is 100 MPa or greater at 0°C and 10 MPa or less at 50°C.

In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative dielectric constant of the polymer material having a viscoelasticity at room temperature is 10 or greater at 25°C. Accordingly, in a case where a voltage is applied to the polymer-based piezoelectric composite material, a higher electric field is applied to the piezoelectric particles in the polymer matrix, and thus a large deformation amount can be expected.

However, in consideration of ensuring satisfactory moisture resistance and the like, it is suitable that the relative dielectric constant of the polymer material is 10 or less at 25°C.

Examples of the polymer material having a viscoelasticity at room temperature and satisfying such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, it is preferable to use a material containing a cyanoethyl group and particularly preferable to use cyanoethylated PVA as the polymer material.

Further, these polymer materials in the matrix 24 may be used alone or in combination (mixture) of two or more kinds thereof.

In the matrix 24 formed of such a polymer material having a viscoelasticity at room temperature, a plurality of polymer materials may be used in combination as necessary.

That is, for the purpose of adjusting dielectric characteristics, mechanical characteristics, and the like, other dielectric polymer materials may be added to the matrix 24 in addition to the polymer material having a viscoelasticity at room temperature, such as cyanoethylated PVA, as necessary.

Examples of the dielectric polymer material that can be added thereto include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber.

Among these, a polymer material containing a cyanoethyl group is suitably used.

Further, the number of kinds of the dielectric polymers to be added to the matrix 24 of the piezoelectric layer 12 in addition to the material having a viscoelasticity at room temperature, such as cyanoethylated PVA, is not limited to one, and a plurality of kinds of the materials may be added.

In addition, for the purpose of adjusting the glass transition point Tg, a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica may be added to the matrix 24 in addition to the dielectric polymer materials.

Further, for the purpose of improving the pressure sensitive adhesiveness, a viscosity imparting agent such as rosin ester, rosin, terpene, terpene phenol, or a petroleum resin may be added to the matrix 24.

The addition amount of materials to be added to the matrix 24 of the piezoelectric layer 12 other than the polymer material having a viscoelasticity at room temperature such as cyanoethylated PVA is not particularly limited, but is preferably set to 30% by mass or less in terms of the proportion of the materials in the matrix 24.

In this manner, the characteristics of the polymer material to be added can be exhibited without impairing the viscoelasticity relieving mechanism in the matrix 24, and thus preferable results, for example, an increase in the dielectric constant, improvement of the heat resistance, and improvement of the adhesiveness between the piezoelectric particles 26 and the electrode layer can be obtained.

In the piezoelectric film 10 according to the embodiment of the present invention, the piezoelectric layer 12 contains the piezoelectric particles 26 in such a matrix 24.

Known particles can be used as the piezoelectric particles 26, but it is preferable that the piezoelectric particles 26 consist of ceramic particles having a perovskite type or wurtzite type crystal structure.

Examples of the ceramic particles forming the piezoelectric particles 26 include lead zirconate titanate (PZT), lead lanthanum zirconate titanate (PLZT), barium titanate ($BaTiO_3$), zinc oxide (ZnO), and a solid solution (BFBT) of barium titanate and bismuth ferrite ($BiFe_3$).

The particle diameter of such piezoelectric particles 26 is not limited, and may be appropriately selected depending on the size of the piezoelectric layer 12 (piezoelectric film 10), the applications of the piezoelectric film 10, and the like. The particle diameter of the piezoelectric particles 26 is preferably in a range of 1 to 10 $\mu$m.

By setting the particle diameter of the piezoelectric particles 26 to be in the above-described range, preferable results in terms of achieving both excellent piezoelectric characteristics and flexibility of the piezoelectric film 10 can be obtained.

In Fig. 1, the piezoelectric particles 26 in the piezoelectric layer 12 are irregularly dispersed in the matrix 24, but the present invention is not limited thereto.

That is, the piezoelectric particles 26 in the piezoelectric layer 12 may be irregularly or regularly dispersed in the matrix 24 as long as the piezoelectric particles 26 are preferably uniformly dispersed therein.

Further, the particle diameter of the piezoelectric particles 26 may or may not be uniform.

In the piezoelectric film 10, the ratio between the amount of the matrix 24 and the amount of the piezoelectric particles 26 in the piezoelectric layer 12 is not limited and may be appropriately set according to the size and the thickness of the piezoelectric film 10 in the plane direction, the applications of the piezoelectric film 10, the characteristics required for the piezoelectric film 10, and the like.

The volume fraction of the piezoelectric particles 26 in the piezoelectric layer 12 is preferably in a range of 30% to 80%, more preferably 50% or greater, and still more preferably in a range of 50% to 80%.

By setting the ratio between the amount of the matrix 24 and the amount of the piezoelectric particles 26 to be in the above-described ranges, preferable results in terms of achieving both of excellent piezoelectric characteristics and flexibility can be obtained.

Further, the thickness of the piezoelectric layer 12 in the piezoelectric film 10 is not particularly limited and may be appropriately set according to the applications of the piezoelectric film 10, the characteristics required for the piezoelectric film 10, and the like.

It is advantageous that the thickness of the piezoelectric layer 12 increases in terms of the rigidity such as the strength of stiffness of a so-called sheet-like material, but the voltage (potential difference) required to stretch and contract the piezoelectric film 10 by the same amount increases.

The thickness of the piezoelectric layer 12 is preferably in a range of 8 to 300 $\mu$m, more preferably in a range of 8 to 200 $\mu$m, still more preferably in a range of 10 to 150 $\mu$m, and particularly preferably in a range of 15 to 100 $\mu$m.

By setting the thickness of the piezoelectric layer 12 to be in the above-described ranges, preferable results in terms of achieving both ensuring of the rigidity and moderate elasticity can be obtained.

It is preferable that the piezoelectric layer 12 is subjected to a polarization treatment (poling) in the thickness direction. The polarization treatment will be described in detail later.

In the piezoelectric film according to the embodiment of the present invention, the piezoelectric layer 12 is not limited to the polymer-based piezoelectric composite material as illustrated in the figure, and a known piezoelectric material can be used.

Examples of the piezoelectric material that can be used for the piezoelectric film according to the embodiment of the present invention include polyvinylidene fluoride, a fluororesin other than polyvinylidene fluoride, and a laminated film of a film consisting of poly-L lactic acid and a film consisting of poly-D lactic acid.

However, from the viewpoints of obtaining excellent acoustic characteristics, excellent flexibility, and the like, a polymer-based piezoelectric composite material obtained by dispersing the piezoelectric particle 26 in the matrix 24 containing a polymer material is suitably used as the piezoelectric layer 12.

As illustrated in Fig. 1, the piezoelectric film 10 in the illustrated example includes the first electrode layer 14 on one surface of such a piezoelectric layer 12 and the first protective layer 18 on the surface thereof. Further, the piezoelectric film 10 includes the second electrode layer 16 on a surface of the piezoelectric layer 12 on a side opposite to the first electrode layer 14 and the second protective layer 20 on the surface thereof. In other words, the first protective layer 18 is provided on a surface of the first electrode layer 14 on a side opposite to the piezoelectric layer 12. Further, the second protective layer 20 is provided on a surface of the second electrode layer 16 on a side opposite to the piezoelectric layer 12.

In the piezoelectric film 10, the first electrode layer 14 and the second electrode layer 16 form a pair of electrodes. That is, the piezoelectric film 10 has a configuration in which both surfaces of the piezoelectric layer 12 are sandwiched between the pair of electrodes, that is, the first electrode layer 14 and the second electrode layer 16 and this laminate is sandwiched between the first protective layer 18 and the second protective layer 20.

In such a piezoelectric film 10, the region sandwiched between the first electrode layer 14 and the second electrode layer 16 stretches and contracts according to the applied voltage.

Further, in the present invention, the terms "first" and "second" in the first electrode layer 14 and the second electrode layer 16, and the first protective layer 18 and the second protective layer 20 are used to distinguish two similar members of the piezoelectric film 10 for convenience.

The same applies to the lead wire and the filling member described below.

That is, the terms "first" and "second" of the respective constituent elements of the piezoelectric film 10 have no technical meaning.

The first protective layer 18 and the second protective layer 20 in the piezoelectric film 10 have a function of coating the first electrode layer 14 and the second electrode layer 16 and imparting moderate rigidity and mechanical strength to the piezoelectric layer 12. That is, the piezoelectric layer 12 consisting of the matrix 24 and the piezoelectric particles 26 in the piezoelectric film 10 exhibits extremely excellent flexibility under bending deformation at a slow vibration, but may have insufficient rigidity or mechanical strength depending on the applications.

As a compensation for this, the piezoelectric film 10 is provided with the first protective layer 18 and the second protective layer 20.

The first protective layer 18 and the second protective layer 20 are not limited, and various sheet-like materials can be used, and suitable examples thereof include various resin films.

Among these, from the viewpoints of excellent mechanical characteristics and heat resistance, a resin film consisting of polyethylene terephthalate (PET), polypropylene (PP), polystyrene (PS), polycarbonate (PC), polyphenylene sulfite (PPS), polymethylmethacrylate (PMMA), polyetherimide (PEI), polyimide (PI), polyethylene naphthalate (PEN), triacetyl cellulose (TAC), and a cyclic olefin-based resin is suitably used.

The thickness of the first protective layer 18 and the second protective layer 20 is not limited. In addition, the thicknesses of the first protective layer 18 and the second protective layer 20 are basically the same as each other, but may be different from each other.

Here, in a case where the rigidity of the first protective layer 18 and the second protective layer 20 is extremely high, not only is the stretch and contraction of the piezoelectric layer 12 constrained, but also the flexibility is impaired. Therefore, it is advantageous that the thickness of the first protective layer 18 and the second protective layer 20 is as small as possible except for a case where the mechanical strength, satisfactory handleability as a sheet-like material, and the like are required.

In a case where the thickness of the first protective layer 18 and the second protective layer 20 in the piezoelectric film 10 is two times or less the thickness of the piezoelectric layer 12, preferable results in terms of achieving both ensuring of the rigidity and moderate elasticity can be obtained.

For example, in a case where the thickness of the piezoelectric layer 12 is 50 $\mu$m, the thickness of the first protective layer 18 and the second protective layer 20 is preferably 100 $\mu$m or less, more preferably 50 $\mu$m or less, and still more preferably 25 $\mu$m or less.

In the piezoelectric film 10, the first electrode layer 14 is provided between the piezoelectric layer 12 and the first protective layer 18, and the second electrode layer 16 is provided between the piezoelectric layer 12 and the second protective layer 20.

The first electrode layer 14 and the second electrode layer 16 are provided to apply a voltage to the piezoelectric layer 12.

In the present invention, the material for forming the first electrode layer 14 and the second electrode layer 16 is not limited, and various conductors can be used as the material. Specific examples thereof include metals such as carbon, palladium, iron, tin, aluminum, nickel, platinum, gold, silver, copper, titanium, chromium, and molybdenum, alloys thereof, laminates and composites of these metals and alloys, and indium tin oxide. Among these, copper, aluminum, gold, silver, platinum, and indium tin oxide are suitable as the first electrode layer 14 and the second electrode layer 16.

In addition, a method of forming the first electrode layer 14 and the second electrode layer 16 is not limited, and various known methods can be used. Examples thereof include a film forming method such as a vapor-phase deposition method (vacuum film forming method) such as vacuum vapor deposition or sputtering, a film forming method using plating, and a method of bonding a foil formed of the materials described above.

Among these, from the viewpoint of ensuring the flexibility of the piezoelectric film 10, a thin film made of copper, aluminum, or the like formed by vacuum vapor deposition is suitably used as the first electrode layer 14 and the second electrode layer 16. Among these, particularly a thin film made of copper formed by vacuum vapor deposition is suitably used.

The thicknesses of the first electrode layer 14 and the second electrode layer 16 are not limited. In addition, the thicknesses of the first electrode layer 14 and the second electrode layer 16 are basically the same as each other, but may be different from each other.

Here, similarly to the first protective layer 18 and the second protective layer 20 described above, in a case where the rigidity of the first electrode layer 14 and the second electrode layer 16 is extremely high, not only is the stretch and contraction of the piezoelectric layer 12 constrained, but also the flexibility is impaired. Therefore, it is advantageous that the thicknesses of the first electrode layer 14 and the second electrode layer 16 decrease in a case where the electric resistance is not extremely high.

It is suitable that the product of the thickness and the Young's modulus of the first electrode layer 14 and the second electrode layer 16 of the piezoelectric film 10 is less than the product of the thickness and the Young's modulus of the first protective layer 18 and the second protective layer 20 from the viewpoint that the flexibility is not considerably impaired.

For example, in a combination in which the first protective layer 18 and the second protective layer 20 are made of PET (Young's modulus: approximately 6.2 GPa) and the first electrode layer 14 and the second electrode layer 16 are made of copper (Young's modulus: approximately 130 GPa), in a case where the thickness of the first protective layer 18 and the second protective layer 20 is assumed to be 25 $\mu$m, the thickness of the first electrode layer 14 and the second electrode layer 16 is preferably 1.2 $\mu$m or less, more preferably 0.3 $\mu$m or less, and still more preferably 0.1 $\mu$m or less.

As described above, the piezoelectric film 10 has a configuration in which the piezoelectric layer 12 containing the piezoelectric particles 26 in the matrix 24 containing the polymer material that has a viscoelasticity at room temperature is sandwiched between the first electrode layer 14 and the second electrode layer 16 and this laminate is sandwiched between the first protective layer 18 and the second protective layer 20.

It is preferable that, in such a piezoelectric film 10, the maximal value of the loss tangent (tan$\delta$) at a frequency of 1 Hz according to dynamic viscoelasticity measurement is present at room temperature and more preferable that the maximal value at which the loss tangent is 0.1 or greater is present at room temperature.

In this manner, even in a case where the piezoelectric film 10 is subjected to large bending deformation at a relatively slow vibration of less than or equal to a few Hz from the outside, since the strain energy can be effectively diffused to the outside as heat, occurrence of cracks at the interface between the polymer matrix and the piezoelectric particles can be prevented.

In the piezoelectric film 10, it is preferable that the storage elastic modulus (E') at a frequency of 1 Hz according to the dynamic viscoelasticity measurement is in a range of 10 to 30 GPa at 0°C and in a range of 1 to 10 GPa at 50°C.

In this manner, the piezoelectric film 10 may have large frequency dispersion in the storage elastic modulus (E') at room temperature. That is, the piezoelectric film 10 can exhibit a behavior of being rigid with respect to a vibration of 20 Hz to 20 kHz and being flexible with respect to a vibration of less than or equal to a few Hz.

In the piezoelectric film 10, it is preferable that the product of the thickness and the storage elastic modulus (E') at a frequency of 1 Hz according to the dynamic viscoelasticity measurement is in a range of $1.0 \times 10^6$ to $2.0 \times 10^6$ N/m at 0°C and in a range of $1.0 \times 10^5$ to $1.0 \times 10^6$ N/m at 50°C.

In this manner, the piezoelectric film 10 may have moderate rigidity and mechanical strength within a range not impairing the flexibility and the acoustic characteristics.

Further, in the piezoelectric film 10, it is preferable that the loss tangent (Tan$\delta$) at a frequency of 1 kHz at 25°C is 0.05 or greater in a master curve obtained from the dynamic viscoelasticity measurement.

In this manner, the frequency of a speaker formed of the piezoelectric film 10 is smooth as the frequency characteristic thereof, and thus an amount of a change in acoustic quality in a case where the lowest resonance frequency f0 is changed according to a change in the curvature of the speaker can be decreased.

Further, the piezoelectric film 10 according to the embodiment of the present invention may include a bonding layer for bonding the electrode layer and the piezoelectric layer 12 to each other and a bonding layer for bonding the electrode layer and the protective layer to each other, in addition to the piezoelectric layer 12, the electrode layer, and the protective layer.

The bonding agent may be an adhesive or a pressure sensitive adhesive. Further, the same material as the polymer material obtained by removing the piezoelectric particles 26 from the piezoelectric layer 12, that is, the matrix 24 can also be suitably used as the bonding agent. Further, the bonding layer may be provided on both the first electrode layer 14 side and the second electrode layer 16 side or may be provided only on one of the first electrode layer 14 side or the second electrode layer 16 side.

The piezoelectric film 10 according to the embodiment of the present invention is driven by being connected to an external device such as a power supply device. The piezoelectric film 10 includes the first lead wire 32 and the second lead wire 34 for electrically connecting the piezoelectric film to an external device.

As illustrated in Fig. 1, the first protective layer 18 is provided with the through-hole 18a. The through-hole 18a is filled with the first filling member 36 having conductivity. The first lead wire 32 is laminated and mounted on the first protective layer 18 to cover the first filling member 36 with which the through-hole 18a is filled. In the piezoelectric film 10, the first lead wire 32 and the first electrode layer 14 are electrically connected to each other due to this configuration.

Similarly, the second protective layer 20 is provided with the through-hole 20a. The through-hole 20a is filled with the second filling member 38 having conductivity. The second lead wire 34 is laminated and mounted on the second protective layer 20 to cover the second filling member 38 with which the through-hole 20a is filled. In the piezoelectric film 10, the second lead wire 34 and the second electrode layer 16 are electrically connected to each other due to this configuration.

In the piezoelectric film 10 according to the embodiment of the present invention, in a case where the length of a region on the surface of the first lead wire 32 that is in contact with at least the first filling member 36 in the plane direction is defined as A, and the length of the surface with respect to the length A is defined as B, B/A is 1.5 or greater. Similarly, in a case where the length of a region on the surface of the second lead wire 34 that is in contact with at least the second filling member 38 in the plane direction is defined as A, and the length of the surface with respect to the length A is defined as B, B/A is 1.5 or greater.

As described above, in the piezoelectric film 10 according to the embodiment of the present invention, the terms "first" and "second" provided for the electrode layer, the protective layer, the filling member, the lead wire, and the like have no technical meaning.

Further, the configuration of the connection between the first lead wire 32 and the first electrode layer 14 is the same as the configuration of the connection between the second lead wire 34 and the second electrode layer 16.

Therefore, in a case where it is not necessary to distinguish between the first lead wire 32 and the second lead wire 34 in the following description, both are collectively referred to as "lead wire". In this regard, the same applies to the electrode layer, the protective layer, and the filling member.

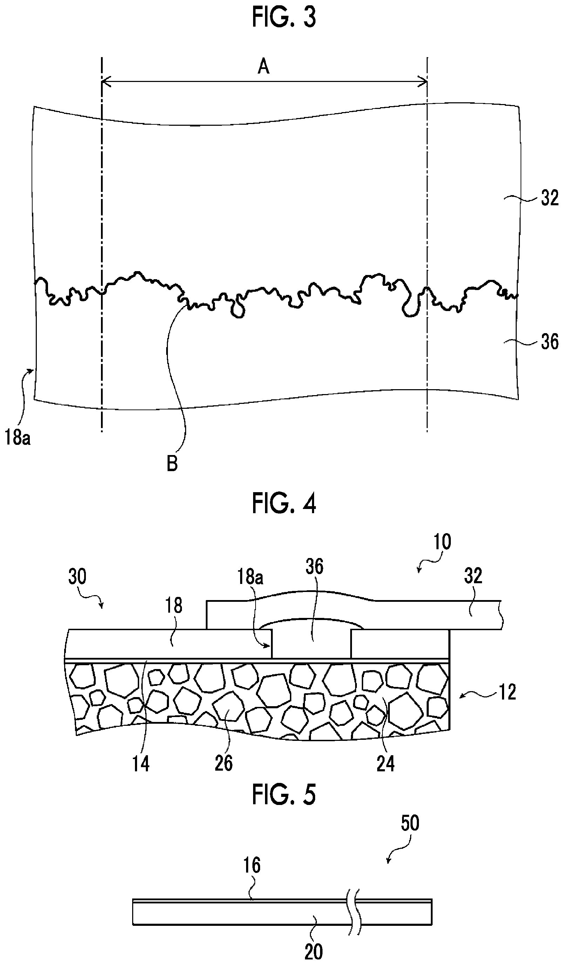

Fig. 3 is a partially enlarged conceptual view illustrating a contact portion between the first lead wire 32 and the first filling member 36 in Fig. 1. Fig. 3 is a cross-sectional view in the thickness direction. Fig. 3 illustrates the first lead wire 32 side as a representative example, and the same applies to the second lead wire 34 side.

As described above, the through-hole 18a formed in the first protective layer 18 is filled with the first filling member 36. Further, the first lead wire 32 is mounted on the first protective layer 18 to cover the entire surface of the first filling member 36 with which the through-hole 18a is filled, in a sheet shape as a preferable aspect.

Here, as illustrated in Fig. 3, the length of the first lead wire 32 in the plane direction in the region in the plane direction is defined as A. Further, the length of the actual surface of the first lead wire 32 with respect to the length A (the region of the length A) in the plane direction is defined as B. In the piezoelectric film 10 according to the embodiment of the present invention, the first lead wire 32 (second lead wire 34) has a ratio B/A of 1.5 or greater (B/A ≥ 1.5) in at least the contact portion with the first filling member 36. That is, in the first lead wire 32, the ratio B/A, which is the length of the surface per unit length in the plane direction, in at least the contact portion with the first filling member 36 is 1.5 or greater.

The lead wire satisfying "B/A ≥ 1.5" has a cross-sectional shape in which the length of the surface is great due to the repetition of simple unevenness and the surface has intricately complex unevenness as conceptually illustrated in Fig. 3.

Specifically, the surface of the lead wire satisfying "B/A ≥ 1.5" has a recess in a cross-sectional shape having a portion with a length greater than that of an open end in the plane direction and/or a projection in a cross-sectional shape having a portion with a length greater than that of a base in the plane direction.

In other words, the surface of the lead wire satisfying "B/A ≥ 1.5" has a recess and/or a projection in a cross-sectional shape that expands and then narrows in the thickness direction, such as a substantially S2 shape or a substantially O shape.

In the piezoelectric film 10 according to the embodiment of the present invention, since the lead wire has such a configuration, the contact length between the filling member and the lead wire can be increased. That is, according to the present invention, the contact area between the filling member and the lead wire can be increased.

As a result, in the piezoelectric film 10 according to the embodiment of the present invention, the connection resistance between the electrode layer and the lead wire can be greatly reduced by increasing the contact area between the conductive material contained in the filling member and the lead wire.

Therefore, the piezoelectric film 10 according to the embodiment of the present invention can be efficiently driven by significantly reducing a loss of driving power supplied to the electrode layer.

In the present invention, the length B of the surface with respect to the length A of the lead wire in the plane direction may be measured, for example, in the following manner.

First, the lead wire is removed from the piezoelectric film 10. In addition, a filling member broken by aggregation failure may be attached to the removed lead wire.

The removed lead wire is embedded in a resin such as an epoxy resin. Thereafter, a cross section including the entire region of the lead wire in the thickness direction is prepared and exposed using a microtome or the like. As the microtome, for example, UC6 (manufactured by Leica Co., Ltd.) or the like is suitably exemplified.

The exposed cross section of the lead wire may be coated with a conductive material such as osmium (OS) as necessary. The thickness of the conductive material may be about 1 nm.

Thereafter, a backscattered electron image of a cross section of the lead wire is acquired by a scanning electron microscope (SEM). Suitable examples of the SEM include SU8220 (manufactured by Hitachi High-Tech Corporation).

Further, the length B of the surface of the lead wire with respect to the length A of the lead wire in the plane direction is measured by tracing the surface of the lead wire on the filling member side in a SEM image of the acquired cross section of the lead wire using image processing software. The ratio B/A of the lead wire is calculated from this measurement result. Various kinds of image processing software having a trace function of tracing the surface by detecting a difference in brightness at an interface can be used. Suitable examples of the image processing software include Image-Pro Plus (manufactured by Media Cybernetics, Inc.).

In the present invention, such calculation of the ratio B/A is performed on ten cross sections optionally selected in the lead wire to be measured. The average value of the calculation results for B/A in eight cross sections obtained by eliminating the maximum value and the minimum value from the calculation results for B/A in the ten cross sections is calculated.

The average value of the calculation results for B/A in the eight cross sections is defined as B/A of the lead wire to be measured, that is, the length of the surface of the lead wire in the unit length of the lead wire in the plane direction.

Further, the length A of the lead wire in the plane direction is not limited. The length A of the lead wire in the plane direction may be appropriately set according to, for example, the size of the through-hole, the magnification of the SEM, the size of the lead wire, the restriction of the cross-sectional processing, and the like.

As an example of the length A of the lead wire in the plane direction, a length of the lead wire in an image captured with a SEM from one end portion to the other end portion in the plane direction, that is, a length of the lead wire in the plane direction in the visual field length of a SEM image is exemplified. Specifically, the length A of the lead wire in the plane direction is preferably in a range of 60 to 100 μm and more preferably in a range of 80 to 100 μm.

In the piezoelectric film 10 according to the embodiment of the present invention, the lead wire satisfies preferably "B/A ≥ 2.0" and more preferably "B/A ≥ 2.5".

It is preferable that the lead wire satisfies "B/A ≥ 2.0" from the viewpoint that the connection resistance between the lead wire and the electrode layer can be further decreased and the connection strength between the lead wire and the filling member can be further increased.

In the piezoelectric film 10, basically, it is preferable that the ratio B/A of the lead wire increases from the viewpoint that the connection resistance between the lead wire and the electrode layer can be decreased. However, it is not preferable that the ratio B/A of the lead wire is extremely large from the viewpoints of the cost of the lead wire, difficulty in preparing the lead wire, and fragility of the uneven portion of the lead wire. In consideration of the viewpoints described above, it is preferable that the lead wire satisfies "B/A ≤ 4.0".

In the present invention, the lead wire may satisfy "B/A ≥ 1.5" in the region in contact with at least the filling member.

Therefore, the entire surface of the lead wire may satisfy "B/A ≥ 1.5", only the entire surface facing the protective layer may satisfy "B/A ≥ 1.5", only the region in contact with the filling member and the vicinity thereof may satisfy "B/A ≥ 1.5", or only the region in contact with the filling member may satisfy "B/A ≥ 1.5".

In the piezoelectric film 10 according to the embodiment of the present invention, the lead wires (the first lead wire 32 and the second lead wire 34) are not limited, and known various lead wires (conductive wires) used to electrically connect two points can be used as long as the lead wire satisfies "B/A ≥ 1.5" as described above.

Examples of the lead wire include a lead wire including a coating layer obtained by coating a surface of a metal foil such as a copper foil, a metal plate such as a copper plate, a metal foil or a metal plate serving as a main body, or the like with a conductive material such as nickel, and a conductor (conductive layer) such as copper which is patterned on a sheet-like base material such as a wiring pattern of a flexible printed circuit (FPC) substrate.

A commercially available product can also be used as long as the lead wire satisfies "B/A ≥ 1.5".

Among these, a lead wire obtained by coating a conductive main body consisting of a metal foil and the like with a conductive material and roughening the surface by coating the main body such that the conductive material is aggregated during the coating of the main body with the conductive material is suitably exemplified.

A method of coating the main body with the conductive material in this lead wire is not limited. Suitable examples of the method of coating the main body with the conductive material include plating, spraying, and coating.

Further, a lead wire in which a typical sheet-like lead wire is processed by a known method to satisfy "B/A ≥ 1.5" can also be used as the lead wire.

In the piezoelectric film according to the embodiment of the present invention, at least one lead wire of the piezoelectric film may satisfy "B/A ≥ 1.5" in the region on the surface in contact with at least the filling member.

That is, in the illustrated example, any one of the first lead wire 32 or the second lead wire 34 may satisfy "B/A ≥ 1.5". Further, as described below, in a case where a plurality of lead wires are connected to one electrode layer, one lead wire in any one of the first electrode layer 14 side or the second electrode layer 16 side may satisfy "B/A ≥ 1.5".

However, in the piezoelectric film according to the embodiment of the present invention, "B/A ≥ 1.5" is satisfied by preferably a plurality of lead wires, more preferably as many lead wires as possible, and still more preferably all the lead wires.

Therefore, in a case where the piezoelectric film 10 includes two lead wires, that is, the first lead wire 32 and the second lead wire 34, it is preferable that both the first lead wire 32 and the second lead wire 34 satisfy "B/A ≥ 1.5" as in the illustrated example.

The shape of the lead wire in the piezoelectric film 10 according to the embodiment of the present invention is not limited, and various shapes such as a sheet shape as in the illustrated example, a columnar shape (rod shape), a columnar shape in which the upper and lower surfaces have an incomplete circular shape or a truncated shape, and a prismatic shape can be used.

Among these, it is preferable that the lead wire has a sheet shape. Further, in the present invention, the sheet shape also includes a film shape, a (flat) plate shape, a (thin) film shape, a layered shape, and the like.

In addition, it is preferable that the lead wire has flexibility.

The planar shape of the lead wire is not limited to a rectangular shape as in the illustrated example, and various known shapes can be used. Further, the planar shape is a shape in a case where the lead wire is viewed in the thickness direction.

The size, for example, the length or the width of the lead wire is not limited, and may be appropriately set according to the size of the piezoelectric film 10, the configuration and the position of an external device connected to the piezoelectric film 10, the material for forming the lead wire, the shape and the planar shape of the lead wire, the driving power of the piezoelectric film 10, and the like.

In addition, the thickness of the lead wire is also not limited, and the thickness at which the conductivity can be sufficiently obtained may be appropriately set according to the material for forming the lead wire, the size of the lead wire, the flexibility required for the lead wire, the shape of the lead wire, and the like.

In the piezoelectric film 10 according to the embodiment of the present invention, the position where the lead wire is mounted is not limited, and any position in the protective layer may be used as long as the position comes into contact with the filling member and can protrude from the piezoelectric film 10 in the plane direction depending on the length or the like of the lead wire.

Here, the piezoelectric film 10 is extremely thin as described above. Therefore, in a case where the first lead wire 32 and the second lead wire 34 are close to each other in the plane direction, there is a possibility that the lead wires come into contact with each other and cause a short circuit.

Therefore, it is preferable that the first lead wire 32 and the second lead wire 34 are provided to be separated from each other in the plane direction so that the first lead wire 32 and the second lead wire 34 do not overlap each other in the plane direction as illustrated in Fig. 2. Further, the expression "the first lead wire 32 and the second lead wire 34 do not overlap each other in the plane direction" denotes that the first lead wire 32 and the second lead wire 34 do not seem to overlap each other in a case where the piezoelectric film 10 is viewed in the thickness direction.

In the examples illustrated in Figs. 1 and 2, the through-holes of the protective layer are both cylindrical (columnar), but the present invention is not limited thereto.

For example, the through-holes of the protective layer may have a prismatic shape such as a triangular prism or a quadrangular prism, or an elliptical columnar shape. That is, the shape of the through-hole is not limited as long as the through-hole penetrates the protective layer in the thickness direction.

However, from the viewpoint of ease of processing and the like, it is preferable that the through-hole has a cylindrical shape.

In addition, the through-hole of the protective layer may have a shape in which the size thereof in the plane direction gradually changes in the thickness direction.

For example, the through-hole 18a and/or the through-hole 20a may have a truncated conical shape, an elliptical frustum shape, a truncated pyramidal shape, or the like that gradually reduces in diameter or expands in diameter toward the piezoelectric layer 12. Even in this case, for the same reason as described above, a truncated conical shape is preferable as the shape of the through-hole.

The size of the through-hole of the protective layer, for example, the diameter of the cylinder in the illustrated example is not limited.

That is, as the size of the through-hole, the size thereof that enables sufficient ensuring of the conductivity may be appropriately set according to the size of the piezoelectric film 10, the widths of the filling member and the lead wire, and the like.

Further, the protective layer may be provided with a plurality of through-holes as necessary.

That is, the piezoelectric film according to the embodiment of the present invention may be formed such that a plurality of lead wires are connected to one electrode layer according to the size of the piezoelectric film, the shape of the piezoelectric film, the driving current supplied to the piezoelectric film, the connection resistance between the electrode layer and the lead wire, the configuration and the position of an external device connected to the piezoelectric film, and the like.

Further, the piezoelectric film according to the embodiment of the present invention may be provided with a plurality of through-holes with respect to one lead wire according to the size of the lead wire, the shape of the lead wire, the contact area between the protective layer and the lead wire, the required connection resistance between the electrode layer and the lead wire, and the size of the through-hole. That is, in the present invention, the electrode layer and one lead wire may be connected to each other by the plurality of through-holes and the filling member.

In the piezoelectric film 10 according to the embodiment of the present invention, the filling members (the first filling member 36 and the second filling member 38) having conductivity are not limited, and various known conductive materials can be used as long as the through-holes can be filled with the conductive materials.

In the present invention, as a preferred example, the filling member is formed of a conductive paste that contains a conductive filler, a binder (resin), a solvent, and the like and is cured by volatilization of the solvent.

As the conductive paste described above, various known conductive pastes can be used as long as the conductive pastes contain a conductive filler, a binder, and a solvent and are cured by volatilization of the solvent. Examples thereof include a silver paste, a copper paste, a nickel paste, a carbon paste, and a gold paste.

In addition, commercially available products such as DOTITE Series (manufactured by Fujikura Kasei Co., Ltd.) can also be suitably used as the conductive paste.

In the present invention, the filling member is not limited to the conductive paste, and various known materials can be used as long as the materials have conductivity such as a conductive adhesive and a conductive coating material, and the through-holes formed in the protective layer can be filled with the materials.

In the example illustrated in Fig. 1, the through-hole of the protective layer is fulfilled with the filling member, but the present invention is not limited thereto.

That is, the through-hole may be filled with the filling member in a state where the through-hole is not fulfilled, for example, in a state where only 80% by volume of the through-hole is filled with the filling member as long as the filling member comes into contact with the lead wire and the electrode layer. However, it is preferable that the through-hole of the protective layer is fulfilled with the filling member from the viewpoint of increasing the contact area between the lead wire and the filling member and decreasing the connection resistance between the lead wire and the electrode layer.

Further, in the piezoelectric film according to the embodiment of the present invention, as the first electrode layer 14 side is conceptually illustrated as an example in Fig. 4, it is preferable that the filling member (first filling member 36) is present continuously to the surface of the protective layer in a region facing the lead wire from the through-hole (through-hole 18a) of the protective layer (first protective layer 18). In this case, it is preferable that the filling member is present continuously to the surface of the protective layer in a region facing the lead wire such that the through-hole of the protective layer is fulfilled with the filling member and the filling member further overflows.

With such a configuration, the contact area between the lead wire and the filling member can be further increased, and the connection resistance between the lead wire and the electrode layer can be further decreased.

In a case where the lead wire is curved as illustrated in Fig. 4, the length of the curved surface of the curved lead wire in the plane direction of the curved surface is defined as the length A.

Hereinafter, an example of the method of producing the piezoelectric film 10 illustrated in Figs. 1 and 2 will be described with reference to the conceptual views of Figs. 5 to 11.

First, as illustrated in Fig. 5, a sheet-like material 50 in which the second electrode layer 16 is formed on the second protective layer 20 is prepared. The sheet-like material 50 may be prepared by forming a copper thin film or the like as the second electrode layer 16 on the surface of the second protective layer 20 by carrying out vacuum vapor deposition, sputtering, plating, or the like.

In a case where the second protective layer 20 is extremely thin and thus the handleability is degraded, the second protective layer 20 with a separator (temporary support) may be used as necessary. Further, a PET film or the like having a thickness of 25 to 100 $\mu$m can be used as the separator. The separator may be removed after thermal compression bonding of the first electrode layer 14 and the first protective layer 18 described below and before lamination of any member on the first protective layer 18.

Meanwhile, the coating material is prepared by dissolving a polymer material having a viscoelasticity at room temperature, such as cyanoethylated PVA, in an organic solvent, adding the piezoelectric particles 26 such as PZT particles thereto, and stirring the solution for dispersion. In the following description, the polymer material having a viscoelasticity at room temperature, such as cyanoethylated PVA, will also be referred to as "viscoelastic material".

The organic solvent is not limited, and various organic solvents such as dimethylformamide (DMF), methyl ethyl ketone, and cyclohexanone can be used.

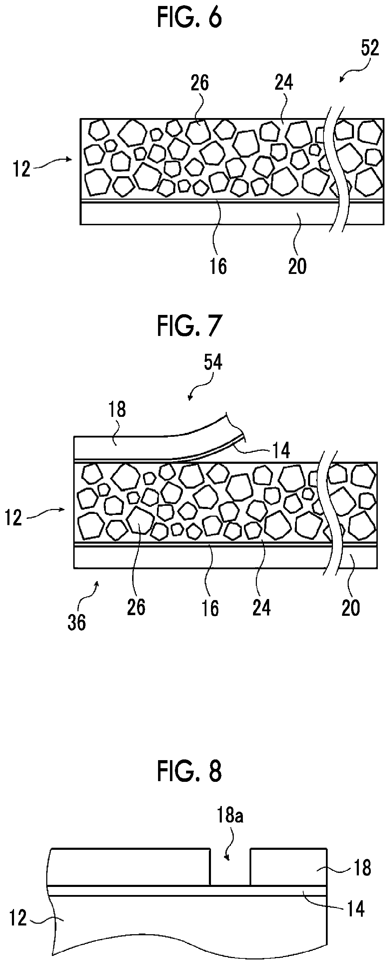

In a case where the sheet-like material 50 is prepared and the coating material is prepared, the coating material is cast (applied) onto the sheet-like material 50, and the organic solvent is evaporated and dried. In this manner, as illustrated in Fig. 6, a laminate 52 in which the second electrode layer 16 is provided on the second protective layer 20 and the piezoelectric layer 12 is formed on the second electrode layer 16 is prepared.

A casting method for the coating material is not particularly limited, and all known coating methods (coating devices) such as a slide coater and a doctor knife can be used.

Further, in a case where the viscoelastic material is a material that can be heated and melted, such as cyanoethylated PVA, the laminate 52 in which the second electrode layer 16 is provided on the second protective layer 20 and the piezoelectric layer 12 is formed on the second electrode layer 16 as illustrated in Fig. 6 may be prepared by heating and melting the viscoelastic material to prepare a melt obtained by adding the piezoelectric particles 26 to the melt to be dispersed therein, extruding the melt on the sheet-like material 50 illustrated in Fig. 5 in a sheet shape by carrying out extrusion molding or the like, and cooling the laminate.

As described above, in the piezoelectric film 10, in addition to the viscoelastic material such as cyanoethylated PVA, a dielectric polymer material such as polyvinylidene fluoride may be added to the matrix 24. In a case where the polymer piezoelectric material is added to the matrix 24, the polymer piezoelectric material to be added to the coating material may be dissolved. Alternatively, the polymer piezoelectric material to be added may be added to the heated and melted viscoelastic material so that the polymer piezoelectric material is heated and melted.

In a case where the laminate 52 in which the second electrode layer 16 is provided on the second protective layer 20 and the piezoelectric layer 12 is formed on the second electrode layer 16 is prepared, the piezoelectric layer 12 is subjected to a polarization treatment (poling).

A method of performing the polarization treatment on the piezoelectric layer 12 is not limited, and a known method can be used. For example, electric field poling in which a DC electric field is directly applied to a target to be subjected to the polarization treatment is exemplified. Further, in a case of performing electric field poling, the electric field poling treatment may be performed using the first electrode layer 14 and the second electrode layer 16 by forming the first electrode layer 14 before the polarization treatment.

Further, in a case where the piezoelectric film 10 according to the embodiment of the present invention is produced, it is preferable that the polarization treatment is performed in the thickness direction of the piezoelectric layer 12 instead of the plane direction.

Before the polarization treatment, a calender treatment may be performed to smoothen the surface of the piezoelectric layer 12 using a heating roller or the like. By performing the calender treatment, a thermal compression bonding step described below can be smoothly performed.

Meanwhile, a sheet-like material 54 in which the first electrode layer 14 is formed on the first protective layer 18 is prepared. The sheet-like material 54 may be the same as the sheet-like material 50 described above.

Next, as illustrated in Fig. 7, the sheet-like material 54 is laminated on the laminate 52 in which the polarization treatment performed on the piezoelectric layer 12 is completed in a state where the first electrode layer 14 is directed to the piezoelectric layer 12. Alternatively, an electric field poling treatment may be performed using the first electrode layer 14 and the second electrode layer 16 after the sheet-like material 54 is laminated on the laminate 52 as described above.

Further, the laminate of the laminate 52 and the sheet-like material 54 is thermally compression-bonded such that the laminate is sandwiched between the second protective layer 20 and the first protective layer 18. A method of performing thermal compression bonding is not limited, and examples thereof include a method of using a heating press device and a method of using a pair of heating rollers. In this manner, the laminate in which the piezoelectric layer is sandwiched between the electrode layers and the protective layers are formed on the surfaces of the electrode layers is prepared. In the following description, the laminate of the piezoelectric layer 12, the electrode layers, and the protective layers will also be referred to as a piezoelectric laminate for convenience.

Alternatively, the piezoelectric laminate may be prepared by bonding and preferably further compression-bonding the laminate 52 and the sheet-like material 54 to each other using a bonding agent.

The piezoelectric laminate (piezoelectric layer 12) to be prepared in the above-described manner is polarized in the thickness direction instead of the plane direction, and thus excellent piezoelectric characteristics are obtained even in a case where the stretching treatment is not performed after the polarization treatment. Therefore, the piezoelectric film 10 has no in-plane anisotropy as a piezoelectric characteristic, and stretches and contracts isotropically in all directions in the plane direction in a case where a driving voltage is applied.

Such a piezoelectric laminate may be produced by using a cut sheet-like material 50, a sheet-like material 54, and the like or by using a long sheet-like material 50, a sheet-like material 54, and the like according to roll-to-roll.

Next, the first lead wire 32 is mounted on the first protective layer 18 of the piezoelectric laminate, and the second lead wire 34 is mounted on the second protective layer 20.

Further, since the mounting of the first lead wire 32 and the mounting of the second lead wire 34 can be performed in the same manner, the mounting of the first lead wire 32 will be described as a representative example in the same manner as described above.

First, as illustrated in Fig. 8, a through-hole 18a (through-hole 20a) is formed in the first protective layer 18 (second protective layer 20).

A method of forming the through-hole 18a is not limited, and a known method may be used depending on the material for forming the first protective layer 18. Examples of the method of forming the through-hole 18a include methods such as laser processing, dissolution removal using a solvent, and mechanical processing such as mechanical polishing.

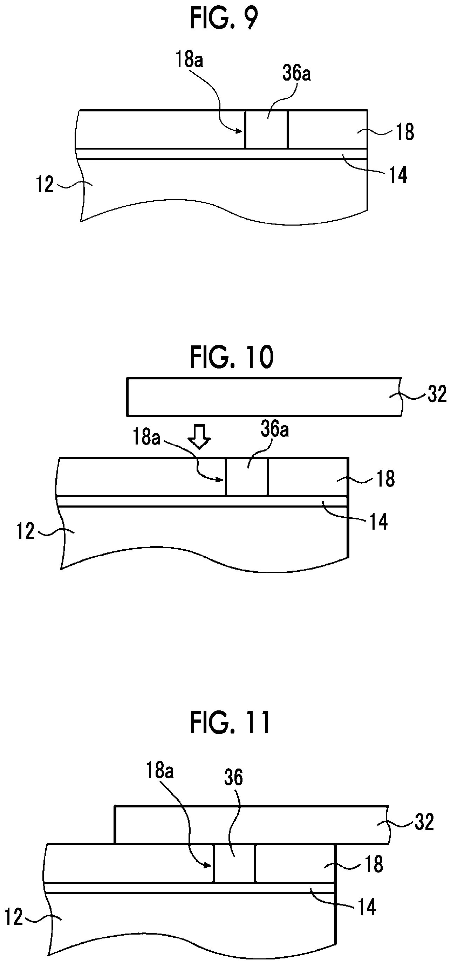

Next, as illustrated in Fig. 9, the through-hole 18a is filled with a material serving as the first filling member 36, for example, a conductive paste 36a.

Further, it is preferable that the through-hole 18a is filled with a sufficient amount of the conductive paste 36a such that the through-hole 18a is fulfilled with the conductive paste 36a.

It is more preferable that the through-hole 18a is filled with the conductive paste 36a in an amount that the conductive paste 36a rises from the through-holes 18a or the conductive paste 36a overflows from the through-holes 18a. In this manner, a piezoelectric film in which the first filling member 36 is present continuously to the surface of the first protective layer 18 in a region facing the first lead wire 32 in a wider range than the through-hole 18a as illustrated in Fig. 4 can be prepared.

Meanwhile, the first lead wire 32 (second lead wire 34) is prepared.

Next, as illustrated in Figs. 10 and 11, the through-hole 18a of the first protective layer 18 and the first lead wire 32 are positioned, and the first lead wire 32 is laminated on the first protective layer 18.

Finally, the piezoelectric film 10 is completed using the conductive paste 36a as the first filling member 36 (second filling member 38) by drying and curing the conductive paste 36a.

In the piezoelectric film 10 according to the embodiment of the present invention, the first protective layer 18 (second protective layer 20) and the first lead wire 32 (second lead wire 34) may be bonded to each other by a known method.

As an example, the first protective layer 18 and the first lead wire 32 may be bonded to each other by using the bonding force of the first filling member 36 (second filling member 38), that is, the conductive paste 36a or the like. In addition, the first protective layer 18 and the first lead wire 32 may be bonded to each other by using a bonding agent consisting of an adhesive, a pressure sensitive adhesive (pressure sensitive adhesive sheet), and the like. Further, the first protective layer 18 and the first lead wire 32 may be bonded to each other by covering at least a part of the first lead wire 32 and bonding bonding tape to the first lead wire 32 and the first protective layer 18. Alternatively, the first protective layer 18 and the first lead wire 32 may be bonded to each other by using a plurality of these methods in combination.

The method of producing the piezoelectric film according to the embodiment of the present invention is not limited to the method illustrated in Figs. 5 to 11, and various methods can be used.

As an example, the piezoelectric film 10 according to the embodiment of the present invention can be suitably used as an electroacoustic transducer (electroacoustic conversion film).

In the piezoelectric film 10, the piezoelectric film 10 is stretched and contracted in the plane direction by applying a driving voltage to the first electrode layer 14 and the second electrode layer 16.

Such a piezoelectric film 10 is held in a state where the piezoelectric film 10 is curved. In the piezoelectric film 10 held in a curved state, in a case where the piezoelectric film 10 is stretched in the plane direction due to application of a voltage to the piezoelectric film 10, the piezoelectric film 10 moves to a projection side (sound radiation direction) in order to absorb the stretched part. On the contrary, in a case where the piezoelectric film 10 is contracted in the plane direction due to application of a voltage to the piezoelectric film 10, the piezoelectric film 10 moves to a recess side in order to absorb the contracted part.

That is, the movement of the piezoelectric film 10 to stretch and contract can be converted into vibration of the piezoelectric film 10 in the thickness direction by holding the piezoelectric film 10 in a curved state.

The piezoelectric film 10 can convert the vibration (sound) and the electric signal by the vibration of the piezoelectric film caused by the repeated stretch and contraction of the film.

As described above, the piezoelectric film 10 according to the embodiment of the present invention can be used for the piezoelectric speaker that reproduces a sound by vibration according to an electric signal input to the piezoelectric film 10 and a voice sensor that converts the vibration of the piezoelectric film 10 caused by receiving a sound wave into an electric signal. Further, the piezoelectric film 10 according to the embodiment of the present invention can also be used as a vibration sensor that detects vibration other than sound waves.

The piezoelectric speaker formed of the piezoelectric film 10 can be stored in a bag or the like by, for example, being rolled or folded using the satisfactory flexibility. Therefore, with the piezoelectric film 10, a piezoelectric speaker that can be easily carried even in a case where the piezoelectric speaker has a certain size can be realized.

Further, as described above, the piezoelectric film 10 has excellent elasticity and excellent flexibility, and has no in-plane anisotropy as a piezoelectric characteristic. Therefore, in the piezoelectric film 10, a change in acoustic quality regardless of the direction in which the film is bent is small, and a change in acoustic quality with respect to the change in curvature is also small. Accordingly, the piezoelectric speaker formed of the piezoelectric film 10 has a high degree of freedom of the installation place and can be attached to various products as described above. For example, a so-called wearable speaker can be realized by mounting the piezoelectric film 10 on clothing such as a suit and portable items such as a bag in a curved state.

Further, as described above, the piezoelectric film 10 according to the embodiment of the present invention can be used as a speaker of a display device having flexibility by bonding the piezoelectric film 10 to a display device having flexibility such as an organic electroluminescence display having flexibility or a liquid crystal display having flexibility.

Further, the speaker formed of the piezoelectric film 10 according to the embodiment of the present invention is not limited to such a flexible speaker, and various known configurations can be used.

As illustrated in Fig. 3 of JP2015-109627A, a speaker obtained by storing a viscoelastic support such as wool felt or glass wool in a case having an open upper surface and pressing and fixing the viscoelastic support with the piezoelectric film 10 according to the embodiment of the present invention is described as an example.

As described above, the piezoelectric film 10 stretches and contracts in the plane direction in a case where a voltage is applied, and vibrates suitably in the thickness direction due to the stretch and contraction in the plane direction, and thus a satisfactory acoustic characteristic of outputting a sound with a high sound pressure is exhibited in a case where the piezoelectric film is used as a piezoelectric speaker or the like.

The piezoelectric film 10, which exhibits satisfactory acoustic characteristics, that is, high stretch and contraction performance due to piezoelectricity satisfactorily acts as a piezoelectric vibrating element that vibrates a vibration body such as a vibration plate by laminating a plurality of layers of the piezoelectric films 10 to obtain a laminated piezoelectric element.

The piezoelectric film 10 according to the embodiment of the present invention has satisfactory heat radiation properties. Therefore, the piezoelectric film 10 according to the embodiment of the present invention radiates heat even in a case where a piezoelectric vibrating element is formed by laminating the piezoelectric films, and thus heat generation can be prevented.

Further, in a case of lamination of the piezoelectric films 10, each piezoelectric film may not have the first protective layer 18 and/or the second protective layer 20 unless there is a possibility of a short circuit. Alternatively, the piezoelectric films that do not have the first protective layer 18 and/or the second protective layer 20 may be laminated through an insulating layer.

As an example, the laminated piezoelectric element obtained by laminating a plurality of the piezoelectric films is bonded to a vibration plate and may be used as a speaker in which the vibration plate is vibrated by the laminate of the piezoelectric films 10 to output a sound. That is, in this case, the laminate of the piezoelectric films 10 acts as a so-called exciter that outputs a sound by vibrating the vibration plate.

By applying a driving voltage to the laminated piezoelectric element obtained by laminating the piezoelectric films 10, each of the piezoelectric films 10 stretches and contracts in the plane direction, and the entire laminate of the piezoelectric films 10 stretches and contracts in the plane direction due to the stretch and contraction of each of the piezoelectric films 10. The vibration plate to which the laminate has been bonded is bent due to the stretch and contraction of the laminated piezoelectric element in the plane direction, and as a result, the vibration plate vibrates in the thickness direction. The vibration plate generates a sound using the vibration in the thickness direction. The vibration plate vibrates according to the magnitude of the driving voltage applied to the piezoelectric film 10 and generates a sound according to the driving voltage applied to the piezoelectric film 10.

Therefore, the piezoelectric film 10 itself does not output sound in this case.

Therefore, even in a case where the rigidity of each piezoelectric film 10 is low and the stretching and contracting force thereof is small, the rigidity of the laminated piezoelectric element obtained by laminating the piezoelectric films 10 is increased, and the stretching and contracting force as the entire laminate is increased. As a result, in the laminated piezoelectric element obtained by laminating the piezoelectric films 10, even in a case where the vibration plate has a certain degree of rigidity, the vibration plate is sufficiently bent with a large force and can be sufficiently vibrated in the thickness direction, and thus the vibration plate can generate a sound.

In the laminated piezoelectric element obtained by laminating the piezoelectric films 10, the number of laminated sheets of the piezoelectric films 10 is not limited, and the number of sheets set such that a sufficient amount of vibration is obtained may be appropriately set according to, for example, the rigidity of the vibration plate to be vibrated.

Further, one piezoelectric film 10 can also be used as a similar exciter (piezoelectric vibrating element) in a case where the piezoelectric film has a sufficient stretching and contracting force.

The vibration plate that is vibrated by the laminated piezoelectric element obtained by laminating the piezoelectric films 10 is not limited, and various sheet-like materials (plate-like materials and films) can be used.

Examples thereof include a resin film consisting of polyethylene terephthalate (PET) and the like, foamed plastic consisting of foamed polystyrene and the like, a paper material such as a corrugated cardboard material, a glass plate, and wood. Further, various machines (devices) such as display devices such as an organic electroluminescence display and a liquid crystal display may be used as the vibration plate as long as the devices can be sufficiently bent.

It is preferable that the laminated piezoelectric element obtained by laminating the piezoelectric films 10 is formed by bonding the adjacent piezoelectric films 10 with a bonding layer (bonding agent). Further, it is preferable that the laminated piezoelectric element and the vibration plate are also bonded with a bonding layer.

The bonding layer is not limited, and various layers that can bond materials to be bonded can be used. Therefore, the bonding layer may consist of a pressure sensitive adhesive or an adhesive. It is preferable that an adhesive layer consisting of an adhesive is used from the viewpoint that a solid and hard bonding layer is obtained after the bonding.

The same applies to the laminate formed by folding back the long piezoelectric film 10 described later.

In the laminated piezoelectric element obtained by laminating the piezoelectric films 10, the polarization direction of each piezoelectric film 10 to be laminated is not limited. As described above, it is preferable that the piezoelectric film 10 according to the embodiment of the present invention is polarized in the thickness direction. Accordingly, the polarization direction of the piezoelectric film 10 here is a polarization direction in the thickness direction.

Therefore, in the laminated piezoelectric element, the polarization directions may be the same for all the piezoelectric films 10, and piezoelectric films having different polarization directions may be present.

In a laminated piezoelectric element obtained by laminating the piezoelectric films 10, it is preferable that the piezoelectric films 10 are laminated such that the adjacent piezoelectric films 10 have polarization directions opposite to each other.

In the piezoelectric film 10, the polarity of the voltage to be applied to the piezoelectric layer 12 depends on the polarization direction of the piezoelectric layer 12. Therefore, even in a case where the polarization direction is directed from the first electrode layer 14 toward the second electrode layer 16 or from the second electrode layer 16 toward the first electrode layer 14, the polarity of the first electrode layer 14 and the polarity of the second electrode layer 16 in all the piezoelectric films 10 to be laminated are set to be the same as each other.

Therefore, by reversing the polarization directions of the adjacent piezoelectric films 10, even in a case where the electrode layers of the adjacent piezoelectric films 10 come into contact with each other, the electrode layers in contact with each other have the same polarity, and thus there is no risk of a short circuit.

The laminated piezoelectric element obtained by laminating the piezoelectric films 10 may have a configuration in which a plurality of piezoelectric films 10 are laminated by folding the piezoelectric film 10 once or more times, preferably a plurality of times.

The configuration in which the piezoelectric film 10 is folded back and laminated has the following advantages.

That is, in the laminate in which a plurality of cut sheet-like piezoelectric films 10 are laminated, the first electrode layer 14 and the second electrode layer 16 need to be connected to a driving power supply for each piezoelectric film.

On the contrary, in the configuration in which the long piezoelectric film 10 is folded back and laminated, only one sheet of the long piezoelectric film 10 can form the laminated piezoelectric element. Therefore, in the configuration in which the long piezoelectric film 10 is folded back and laminated, the number of power supplies necessary to apply the driving voltage is only one, and the lead out of the piezoelectric film 10 from each electrode layer to the lead wire may be made at one site.

Further, in the configuration in which the long piezoelectric film 10 is folded back and laminated, the polarization directions of the adjacent piezoelectric films 10 are inevitably opposite to each other.

Further, such a laminated piezoelectric element obtained by providing electrode layers on both surfaces of a piezoelectric layer consisting of a polymer-based piezoelectric composite material and preferably by laminating piezoelectric films in which a protective layer is provided on the surface of an electrode layer is described in WO2020/095812A and WO2020/179353A.

The piezoelectric film according to the embodiment of the present invention and the laminated piezoelectric element obtained by laminating the piezoelectric films can be suitably used for various applications, such as various sensors, acoustic devices, haptics, ultrasonic transducers, actuators, damping materials (dampers), and vibration power generation devices.

Specifically, examples of the sensors formed of the piezoelectric film according to the embodiment of the present invention and the laminated piezoelectric element obtained by laminating the piezoelectric films include sound wave sensors, ultrasound sensors, pressure sensors, tactile sensors, strain sensors, and vibration sensors. The sensors formed of the piezoelectric film according to the embodiment of the present invention and the laminated piezoelectric element obtained by laminating the piezoelectric films are particularly useful for infrastructure inspection such as crack detection and inspection at a manufacturing site such as foreign matter contamination detection.

Examples of the acoustic devices formed of the piezoelectric film according to the embodiment of the present invention and the laminated piezoelectric element obtained by laminating the piezoelectric films include microphones, pickups, speakers, and exciters. Specific applications of the acoustic devices formed of the piezoelectric film according to the embodiment of the present invention and the laminated piezoelectric element obtained by laminating the piezoelectric films include noise cancellers used in cars, trains, airplanes, robots, and the like, artificial voice cords, buzzers for preventing invasion of pests and harmful animals, furniture having a voice output function, wallpaper, photos, helmets, goggles, headrests, signages, and robots.

Application examples of the haptics formed of the piezoelectric film according to the embodiment of the present invention and the laminated piezoelectric element obtained by laminating the piezoelectric films include automobiles, smartphones, smart watches, and game machines.

Examples of the ultrasonic transducers formed of the piezoelectric film according to the embodiment of the present invention and the laminated piezoelectric element obtained by laminating the piezoelectric films include ultrasound probes and hydrophones.

Examples of the applications of the actuators formed of the piezoelectric film according to the embodiment of the present invention and the laminated piezoelectric element obtained by laminating the piezoelectric films include water droplet adhesion prevention, transport, stirring, dispersion, and polishing.

Application examples of the damping materials formed of the piezoelectric film according to the embodiment of the present invention and the laminated piezoelectric element obtained by laminating the piezoelectric films include containers, vehicles, buildings, and sports goods such as skis and rackets.

Further, application examples of the vibration power generation devices formed of the piezoelectric film according to the embodiment of the present invention and the laminated piezoelectric element obtained by laminating the piezoelectric films include roads, floors, mattresses, chairs, shoes, tires, wheels, and personal computer keyboards.

Hereinbefore, the piezoelectric film according to the embodiment of the present invention has been described in detail, but the present invention is not limited to the above-described examples, and various improvements or modifications may be made within a range not departing from the scope of the present invention.

Examples

Hereinafter, the piezoelectric film according to the embodiment of the present invention will be described in more detail with reference to specific examples of the present invention.

[Preparation of piezoelectric laminate]

Lead oxide powder, zirconium oxide powder, and titanium oxide powder were wet-mixed in a ball mill for 12 hours to prepare raw material mixed powder. Here, the amount of each oxide was set to Zr = 0.52 mol and Ti = 0.48 mol with respect to Pb = 1 mol.

This raw material mixed powder was put into a crucible and fired at 800°C for 5 hours, thereby preparing raw material particles of PZT particles.

By the method illustrated in Figs. 5 to 7 described above, a piezoelectric laminate as illustrated in Fig. 1 which had electrode layers on both surfaces of the piezoelectric layer and had protective layers covering the electrode layers was prepared.

First, cyanoethylated PVA (CR-V, manufactured by Shin-Etsu Chemical Co., Ltd.) was dissolved in methyl ethyl ketone (MEK) at the following compositional ratio. Thereafter, PZT particles were added to the solution at the following compositional ratio and dispersed using a propeller mixer (rotation speed of 2000 rpm), thereby preparing a coating material for forming a piezoelectric layer.

- PZT Particles . . . 300 parts by mass
- Cyanoethylated PVA ⋯ 30 parts by mass
- DMF . . . 70 parts by mass

Further, two sheets of sheet-like materials obtained by performing vacuum vapor deposition on a copper thin film having a thickness of 0.1 μm were prepared on a PET film having a thickness of 4 μm. That is, in the present example, the first electrode layer and the second electrode layer are copper-deposited thin films having a thickness of 0.1 μm, and the first protective layer and the second protective layer are PET films having a thickness of 4 μm.

The second electrode layer (copper-deposited thin film) of one sheet-like material was coated with the coating material for forming the piezoelectric layer prepared in advance using a slide coater. Further, the second electrode layer was coated with the coating material such that the film thickness of the coating film after being dried reached 40 μm.

Next, the material obtained by coating the sheet-like material with the coating material was heated and dried on a hot plate at 120°C to evaporate DMF. In this manner, a laminate in which the second electrode layer made of copper was provided on the second protective layer made of PET and the piezoelectric layer having a thickness of 40 μm was provided thereon was prepared.

The prepared piezoelectric layer was subjected to a polarization treatment in the thickness direction.

The other sheet-like material was laminated on the laminate subjected to a polarization treatment in a state where the first electrode layer (copper thin film side) was directed to the piezoelectric layer.

Next, the piezoelectric layer and the first electrode layer were bonded and adhered to each other by performing thermal compression bonding on the laminate of the laminate and the sheet-like material at a temperature of 120°C using a laminator device.

In this manner, as illustrated in Fig. 1, a piezoelectric laminate in which electrode layers were provided on both surfaces of the piezoelectric layer and protective layers were provided on the surfaces of the electrode layer was prepared.

[Example 1]

The prepared piezoelectric laminate was cut into a rectangle having a size of 200 × 70 mm.

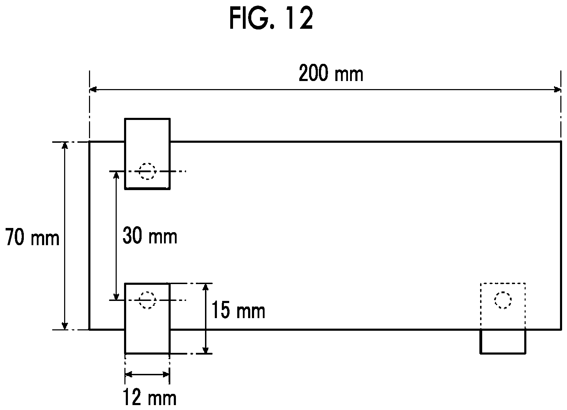

A first lead wire and a second lead wire each having a thickness of 35 μm, a width of 12 mm, and a length of 15 mm were prepared (see Fig. 12). This lead wire was obtained by performing nickel plating with a thickness of 0.5 μm on the surface of copper foil.

A through-hole having a diameter of 5 mm was formed in the first protective layer of the cut piezoelectric laminate using a carbon dioxide gas laser. The through-hole was formed such that the center of the through-hole was at a position separated by 10 mm from one end portion of the piezoelectric laminate in the longitudinal direction and separated by 20 mm from one end portion thereof in the lateral direction.

The through-hole was filled with a conductive paste (DOTITE D550, (manufactured by Fujikura Kasei Co., Ltd.). The through-hole of the protective layer was filled with the conductive paste to rise from the through-hole.

Next, the first lead wire was laminated and mounted on the first protective layer such that the center of the through-hole of the protective layer was the center of the lead wire in the width direction (12 mm) and was separated by 5 mm from an end portion in the longitudinal direction (15 mm) (see Fig. 12).

The second lead wire was laminated and mounted on the second protective layer in the same manner as that for the first lead wire such that the center of the through-hole was at a position line-symmetrical with respect to the center of the piezoelectric film in the longitudinal direction.

After the lead wire was mounted, the conductive paste was allowed to stand for 47 hours or longer to be completely dried to form a filling member, thereby preparing a piezoelectric film as illustrated in Figs. 1 and 2. Further, both lead wires were bonded to the protective film by the bonding force of the conductive paste.

In this example, the filling member was wider than the through-hole of the protective layer and was present up to the region on the surface of the protective layer facing the lead wire.

With respect to the prepared piezoelectric film, the length B of the surface of the first lead wire with respect to the length A of the first lead wire in the plane direction was measured as follows.

In this example, since the first lead wire and the second lead wire used here were the same as each other, the length B of the surface of the lead wire with respect to the length A of the second lead wire in the plane direction was considered to be substantially the same as that for the first lead wire. In this regard, the same applies to the other examples.

The first lead wire was removed from the prepared piezoelectric film. The removed first lead wire was embedded in an epoxy resin.

A cross section including the entire layer of the first lead wire in the thickness direction was prepared by using an ultramicrotome (UC6, manufactured by Leica Co., Ltd.). The conditions for finishing processing of the microtome were a speed of 1 mm/s and a feed of 250 nm. As a diamond knife, an Ultratrim (manufactured by Diatome) was used.

The cross section of the first lead wire processed with the microtome was subjected to osmium coating (Os coating, coating thickness of approximately 1 nm) using an osmium coater (HPC-30W, manufactured by Vacuum Device Inc.).

Thereafter, a cross section of the first lead wire was observed using a SEM (SU8220, manufactured by Hitachi High-Tech Corporation), and a backscattered electron image of the cross section of the first lead wire in which an X-axis direction of the image was set as the plane direction of the first lead wire and a Y-axis direction of the image was set as the thickness direction of the first lead wire was acquired. A digital SEM image with 512 dpi (dots per inch) was acquired under the SEM observation conditions of an acceleration voltage of 2 kV, a working distance of 3 mm, a detection signal Upper detector LA100, and a magnification of 1500 times.

Such cross-sectional images of the first lead wire were acquired in optional ten cross sections of the first lead wire.

The length B of the surface of the first lead wire with respect to the length A in the plane direction was measured by analyzing the SEM images using image processing software (Image-Pro Plus, manufactured by Media Cybernetics, Inc.).

First, the acquired SEM images of ten cross sections of the first lead wire at a magnification of 1500 times were taken into image processing software. The SEM images were subjected to a Gaussian filter treatment (size: 7, number of times: 1, strength: 10) before the SEM images were taken into the image processing software.

Next, the length B of the surface of the first lead wire with respect to the length A in the plane direction was measured by using the trace function of the manual measurement of the image processing software. The tracing was performed under conditions of a threshold value of 3, smoothing of 2, a speed of 2, and a noise of 1.

The measurement range, that is, the length A in the plane direction was defined as the length A from a start point to an end point in the plane direction by setting the left end of the first lead wire surface on the filling member side as the start point and the right end of the first lead wire surface on the filling member side as the end point in the SEM images taken into the software. Further, the length A in the plane direction was 84.8 $\mu$m.

The ratio B/A was calculated from the length A of the first lead wire in the plane direction and the measured length B of the surface of the first lead wire in the region of the length A.

The ratio B/A was calculated for all of the SEM images of ten cross sections of the first lead wire, and the average value of the calculation results for B/A in eight cross sections of the first lead wire obtained by eliminating the maximum value and the minimum value from the calculation results for B/A in the ten cross sections was calculated and defined as B/A of the first lead wire in the piezoelectric film.

As a result, the ratio B/A of the first lead wire of this piezoelectric film was 1.5.

Further, the ratio B/A of the first lead wire was measured after the resistance value described below was measured.

[Example 2]

A piezoelectric film was prepared in the same manner as in Example 1 except that the lead wire was changed.

Further, this lead wire was obtained by performing nickel plating on the surface of a copper foil and had the same shape and the same thickness as in Example 1, but the plating conditions were different from those of the lead wire in Example 1, and thus the surface properties thereof were different from each other due to different plating conditions.

The ratio B/A of the first lead wire was calculated in the same manner as in Example 1.

As a result, the ratio B/A of the first lead wire of this piezoelectric film was 2.

[Example 3]

A piezoelectric film was prepared in the same manner as in Example 1 except that the lead wire was changed.

Further, this lead wire was obtained by performing nickel plating on the surface of a copper foil and had the same shape and the same thickness as in Example 1, but the plating conditions were different from those of the lead wire in Example 1, and thus the surface properties thereof were different from each other due to different plating conditions.

The ratio B/A of the first lead wire was calculated in the same manner as in Example 1.

As a result, the ratio B/A of the first lead wire of this piezoelectric film was 2.5.

[Example 4]

A piezoelectric film was prepared in the same manner as in Example 3 except that, in the filling of the through-hole of the protective layer with the conductive paste, the conductive paste was aligned with the upper end of the through-hole. In this piezoelectric film, the filling member (conductive paste) was positioned only in the through-hole.

The ratio B/A of the first lead wire was calculated in the same manner as in Example 1.

As a result, the ratio B/A of the first lead wire of this piezoelectric film was 2.5.

[Example 5]

A piezoelectric film was prepared in the same manner as in Example 3 except that the diameter of the through-hole formed in the protective layer was set to 2 mm.

The ratio B/A of the first lead wire was calculated in the same manner as in Example 1.

As a result, the ratio B/A of the first lead wire of this piezoelectric film was 2.5.

[Comparative Example 1]

A piezoelectric film was prepared in the same manner as in Example 1 except that the lead wire was changed.

Further, this lead wire was obtained by performing nickel plating on the surface of a copper foil and had the same shape and the same thickness as in Example 1, but the plating conditions were different from those of the lead wire in Example 1, and thus the surface properties thereof were different from each other due to different plating conditions.

The ratio B/A of the first lead wire was calculated in the same manner as in Example 1.

As a result, the ratio B/A of the first lead wire of this piezoelectric film was 1.3.

[Comparative Example 2]

A piezoelectric film was prepared in the same manner as in Example 1, except that the lead wire was changed to a copper foil having a thickness of 35 $\mu$m, a width of 12 mm, and a length of 15 mm.

The ratio B/A of the first lead wire was calculated in the same manner as in Example 1.

As a result, the ratio B/A of the first lead wire of this piezoelectric film was 1.05.

[Measurement of electric resistance]

In the prepared piezoelectric film, the electric resistances of the connection portion between the first electrode layer and the first lead wire was measured using an LCR meter (ZM2372, manufactured by NF Circuit Design Block Co., Ltd.).

As conceptually illustrated in Fig. 12, the electric resistance was measured by mounting a lead wire similar to the first lead wire such that the through-holes were line-symmetrical with respect to the center line of the piezoelectric film in the lateral direction and measuring the electric resistance between the lead wires. Therefore, the distance between the centers of the through-holes to be measured was 30 mm.

The measurement results are listed in Table 1.

[Table 1]

|  |  | B/A | Region where filling member is present | Diameter of through-hole in protective layer [mm] | Electric resistance [$\Omega$] |
|---|---|---|---|---|---|
|  | Example 1 | 1.5 | Wider range than through-hole in protective layer | 5 | 1 |
|  | Example 2 | 2 | Wider range than through-hole in protective layer | 5 | 0.8 |
|  | Example 3 | 2.5 | Wider range than through-hole in protective layer | 5 | 0.5 |
|  | Example 4 | 2.5 | Same range as range of through-hole in protective layer | 5 | 0.7 |
|  | Example 5 | 2.5 | Wider range than through-hole in protective layer | 2 | 0.5 |

(continued)

|  | B/A | Region where filling member is present | Diameter of through-hole in protective layer [mm] | Electric resistance [Ω] |
|---|---|---|---|---|
| Comparative Example 1 | 1.3 | Wider range than through-hole in protective layer | 5 | 1.2 |
| Comparative Example 2 | 1.05 | Wider range than through-hole in protective layer | 5 | 1.5 |
| B/A denotes the length of the surface of the lead wire per unit length in the plane direction | | | | |

As listed in Table 1, according to the piezoelectric film according to the embodiment of the present invention in which the ratio B/A of the first lead wire was 1.5 or greater, the connection resistance between the first lead wire and the electrode layer was 1 Ω or less, and the connection resistance between the first lead wire and the electrode layer could be reduced.

In addition, as shown in Examples 1 to 3, in the piezoelectric film according to the embodiment of the present invention, the connection resistance between the lead wire and the electrode layer could be further reduced by increasing the ratio B/A of the lead wire. Further, as shown in Examples 3 and 4, in the piezoelectric film according to the embodiment of the present invention, the connection resistance between the lead wire and the electrode layer could be further reduced by providing the filling member in a wider range than the through-hole so that the filling member was brought into contact with the lead wire. Further, as shown in Examples 3 and 5, according to the piezoelectric film according to the embodiment of the present invention, the connection resistance between the lead wire and the electrode layer could be sufficiently reduced even in a case where the through-hole for connecting the lead wire and the electrode layer was made small.

On the contrary, in Comparative Example 1 and Comparative Example 2 in which the ratio B/A of the first lead wire was less than 1.5, the connection resistance between the first lead wire and the electrode layer was greater than 1 Ω.

As shown in the results described above, the effects of the present invention are apparent.

The present invention can be suitably used for electroacoustic transducers such as speakers, vibration sensors, and the like.

Explanation of References

    10: piezoelectric film
    12: piezoelectric layer
    14: first electrode layer
    16: second electrode layer
    18: first protective layer
    18a, 20a: through-hole
    20: second protective layer
    24: matrix
    26: piezoelectric particle
    30: piezoelectric film
    32: first lead wire
    34: second lead wire
    36: first filling member
    36a: conductive paste
    38: second filling member
    50, 54: sheet-like material

Claims

1. A piezoelectric film comprising:

    a piezoelectric layer;
    electrode layers provided on both surfaces of the piezoelectric layer;

21

protective layers provided to cover the electrode layers and having one or more through-holes;
a conductive filling member which fills the through-holes of the protective layer; and
lead wires provided in contact with the filling member and to connect the piezoelectric film with an external device,
wherein in at least one of the lead wires, in a case where a length of a region on a surface, which is in contact with at least the filling member, in a plane direction is defined as A, and a length of the surface with respect to the length A in the plane direction is defined as B, B/A is 1.5 or greater.

2. The piezoelectric film according to claim 1,
wherein the through-holes of the protective layer are fulfilled with the filling member.

3. The piezoelectric film according to claim 1 or 2,
wherein the lead wire includes a conductive main body and a conductive coating layer with which the main body is coated.

4. The piezoelectric film according to any one of claims 1 to 3,
wherein the filling member is present continuously from the through-holes of the protective layer to a surface of the protective layer, which faces the lead wire.

5. The piezoelectric film according to any one of claims 1 to 4,
wherein the surface of the region of the lead wire, which is in contact with at least the filling member, has at least one of a recess having a portion with a length in the plane direction greater than a length of an open end in the plane direction or a projection having a portion with a length in the plane direction greater than a length of a base in the plane direction.

6. The piezoelectric film according to any one of claims 1 to 5,
wherein the lead wire has a sheet shape.

7. The piezoelectric film according to any one of claims 1 to 6,
wherein the piezoelectric layer is a polymer-based piezoelectric composite material that contains piezoelectric particles in a matrix containing a polymer material.

8. The piezoelectric film according to claim 7,
wherein the polymer material contains a cyanoethyl group.

# FIG. 1

# FIG. 2

## FIG. 3

A

32

36

18a

B

## FIG. 4

10

30

18a     36     32

18

12

14     26     24

## FIG. 5

50

16

20

## FIG. 6

## FIG. 7

## FIG. 8

## FIG. 9

18a      36a

18

14

12

## FIG. 10

32

18a      36a

18

14

12

## FIG. 11

18a    36

32

18

14

12

# FIG. 12

## INTERNATIONAL SEARCH REPORT

International application No.

**PCT/JP2021/048844**

### A. CLASSIFICATION OF SUBJECT MATTER

*H04R 17/00*(2006.01)i; *H01L 41/047*(2006.01)i; *H01L 41/053*(2006.01)i; *H01L 41/09*(2006.01)i; *H01L 41/18*(2006.01)i
FI: H01L41/047; H01L41/053; H01L41/09; H01L41/18; H04R17/00

According to International Patent Classification (IPC) or to both national classification and IPC

### B. FIELDS SEARCHED

Minimum documentation searched (classification system followed by classification symbols)

H04R17/00; H01L41/047; H01L41/053; H01L41/09; H01L41/18

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2016-15354 A (FUJIFILM CORP.) 28 January 2016 (2016-01-28) paragraphs [0027], [0029], [0030], [0035], [0067], [0069], [0080], [0085], fig. 1(B), 2(C) | 1, 2, 4-8 |
| A | | 3 |
| Y | JP 2009-252950 A (HONDA MOTOR CO., LTD.) 29 October 2009 (2009-10-29) paragraphs [0004], [0005], [0024] - [0028], [0033] - [0036], fig. 1-3 | 1, 2, 4-8 |
| A | | 3 |
| Y | JP 2001-111126 A (SUMITOMO METAL (SMI) ELECTRONICS DEVICES, INC., SUMITOMO METAL INDUSTRIES, LTD.) 20 April 2001 (2001-04-20) paragraphs [0010]-[0016], fig. 1 | 5, 6 |
| A | | 1-4, 7, 8 |
| Y | JP 2014-209724 A (FUJIFILM CORP.) 06 November 2014 (2014-11-06) paragraphs [0025]-[0027], fig. 2 | 6 |
| A | | 1-5, 7, 8 |
| A | JP 2015-41650 A (SEIKO EPSON CORP.) 02 March 2015 (2015-03-02) entire text, all drawings | 1-8 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **24 February 2022** | **08 March 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2021/048844**

| Patent document cited in search report | | | Publication date (day/month/year) | Patent family member(s) | Publication date (day/month/year) |
|---|---|---|---|---|---|
| JP | 2016-15354 | A | 28 January 2016 | (Family: none) | |
| JP | 2009-252950 | A | 29 October 2009 | (Family: none) | |
| JP | 2001-111126 | A | 20 April 2001 | (Family: none) | |
| JP | 2014-209724 | A | 06 November 2014 | US 2016/0014527 A1<br>paragraphs [0077]-[0079], fig. 2A, 2B<br>WO 2014/157006 A1 | |
| JP | 2015-41650 | A | 02 March 2015 | US 2015/0052715 A1<br>entire text, all drawings | |

Form PCT/ISA/210 (patent family annex) (January 2015)

**REFERENCES CITED IN THE DESCRIPTION**

**Patent documents cited in the description**

- JP 2015029270 A
- JP 2015109627 A
- WO 2020095812 A
- WO 2020179353 A